# FASCICULE DE BREVET EUROPEEN

(11) **EP 3 040 284 B1**
(45) Date de publication et mention de la délivrance du brevet: **06.12.2017**
(21) Numéro de dépôt: 14307224.7
(22) Date de dépôt: 31.12.2014
(51) Int. Cl.: B64G 1/42, B64G 1/44, B64G 1/50, B64G 1/66, H01L 35/30

(54) **Dispositif de récupération d'énergie thermique dissipée par un satellite placé dans le vide**
Vorrichtung zur Rückgewinnung von Wärmeenergie, die von einem im Vakuum befindlichen Satelliten abgegeben wird
Device for recovering thermal energy dissipated by a satellite placed in a vacuum

(43) Date de publication de la demande: 06.07.2016
(73) Titulaire: Airbus Group SAS, 75016 Paris (FR)
(72) Inventeur: Geneste, Jean-François, 31200 TOULOUSE (FR)
(74) Mandataire: Ipside

(56) Documents cités:
- EP-A1- 1 980 491
- EP-A2- 2 733 756
- WO-A2-2010/040957
- FR-A1- 2 945 030
- US-A1- 2003 200 221

## Description

### Domaine de l'invention

La présente invention concerne, de façon générale, le domaine des véhicules spatiaux. Elle concerne plus particulièrement les dispositifs d'alimentation énergétique desdits véhicules spatiaux.

L'invention vise encore plus particulièrement un dispositif de récupération d'énergie dissipée en chaleur par un véhicule spatial.

### Etat de l'art

Les satellites, par exemple de télécommunications, nécessitent une quantité importante d'énergie électrique pour alimenter leur charge utile.

De façon classique, l'alimentation en énergie de véhicules spatiaux tels que des satellites en orbite terrestre, est réalisée par utilisation de panneaux de cellules photovoltaïques. Ces cellules, par exemple réalisées en arséniure de Gallium, présentent un rendement de l'ordre de 30%. Le coût de ces cellules est très élevé et se traduit, au niveau du satellite complet, par un budget de panneaux photovoltaïques qui peut atteindre 20% du coût total du satellite. Ces panneaux sont par ailleurs fragiles, et leur rendement vient diminuer au cours de la vie du satellite.

Le document EP 1 980 491 A1 divulgue un dispositif de récupération d'une partie de l'énergie dissipée par les équipements d'un satellite.

### Exposé de l'invention

A cet effet, l'invention vise en premier lieu un dispositif de récupération d'une partie de l'énergie dissipée par effet Joule par les équipements d'un satellite prédéterminé placé en ambiance de vide, ce dispositif de récupération comprenant des panneaux radiatifs dimensionnés pour permettre le refroidissement de la charge utile du satellite, et un générateur thermoélectrique dont la source chaude est alimentée en photons infrarouges par les panneaux radiatifs, ceux-ci étant configurés pour concentrer lesdits photos infrarouges vers ladite source chaude.

Il est connu que la chaleur dissipée par les équipements électroniques du satellite représente aux alentours des quatre cinquièmes de l'énergie électrique consommée par ces équipements. Cette chaleur doit être évacuée vers l'espace pour éviter au satellite de surchauffer. Il est alors judicieux de récupérer une partie de cette chaleur dissipée pour produire à nouveau de l'énergie électrique, ce qui réduit le besoin d'alimentation du satellite par rayonnement solaire, et par exemple réduit la surface de panneaux photovoltaïques nécessaire.

L'invention utilise les panneaux radiatifs servant au refroidissement du satellite (à des températures relativement faibles de l'ordre de 80°C), orientés dans une direction ne faisant pas face au soleil, pour concentrer et transférer de la chaleur vers la source chaude (à une température très nettement supérieure à 80°C) d'un dispositif d'alimentation électrique, par exemple de type générateur thermo-acoustique. Cette transmission peut paraître paradoxale puisque c'est la source froide qui va réchauffer la source chaude.

Récemment, un certain nombre de publications ont fait état d'une alternative aux panneaux solaires classiques pour les satellites, basée sur des systèmes thermoélectriques qui consistent à transformer le rayonnement solaire en chaleur et la chaleur en électricité. Parmi ces possibilités, le moteur thermo acoustique a retenu l'attention de l'agence spatiale européenne.

Par ailleurs, dans les satellites à forte puissance, de télécommunications en particulier, les pertes par effet Joule peuvent se révéler importantes, jusqu'à 80%. La récupération de cette énergie d'habitude perdue, constitue donc un enjeu majeur pour diminuer la taille des panneaux solaires, la surface se payant toujours par de la complexité et du poids. Néanmoins, dans un système thermoélectrique efficace, pour des raisons liées au rendement de Carnot, la température de source chaude est très élevée et dépasse parfois 1000°C. Il se trouve hélas que les pertes par effet Joule se font à des températures bien plus basses, de l'ordre de 80°C. En conséquence, à cause du deuxième principe de la thermodynamique, il n'est potentiellement pas possible de récupérer, dans une source chaude à 1000°C, une chaleur émise à 80°C. Il se trouve pourtant que les conditions spatiales et notamment celles du vide où les échanges thermiques ne peuvent se faire que par radiations, vont, d'une certaine façon, permettre de « flouer » le deuxième principe et vont donc permettre, dans ces conditions très particulières, de réchauffer de manière passive une source chaude avec une source froide.

C'est ce problème très particulier que se propose de résoudre l'invention, par exemple telle que décrite plus loin dans le cadre d'un exemple de satellite de télécommunications. Selon l'invention, au moins un panneau radiatif se présente sous la forme d'une surface, dont une face est radiative, alors que l'autre face est isolée, de manière à éviter le rayonnement, notamment vers le corps du satellite, le panneau radiatif étant incurvé de manière à ce que la plus grande partie possible des photons émis par ledit panneau radiatif convergent vers une zone prédéterminée de l'espace face audit panneau radiatif.

Dans divers modes de réalisation, éventuellement utilisés en conjonction lorsque cela est techniquement possible
- le panneau radiatif est configuré sous forme d'une surface sensiblement rectangulaire, incurvée autour d'un axe longitudinal X de manière à présenter une section parabolique perpendiculairement à cet axe longitudinal X.
- le panneau radiatif est réalisé sous forme d'un ensemble de surfaces planes connexes articulées empilables, disposées lorsqu'elles sont déployées, de façon à approximer un cylindre parabolique. Selon l'invention, la source chaude est disposée en la zone de focalisation des rayons émis par la surface émettrice du panneau radiatif, cette source chaude étant isolée thermiquement, sauf en une zone d'entrée des rayonnements thermiques reçus du panneau radiatif.

La source froide, du fait de son angle solide de vision voit l'espace profond dont la source chaude ne représente qu'une infime partie. Dans ces conditions, la température moyenne qu'elle voit va être inférieure à sa température et elle va donc émettre un rayonnement infra-rouge dont le point focal sera la source chaude. Ladite source chaude aura elle-même un angle solide de vision qui verra une température moyenne de fond inférieure à sa température elle émettra donc elle aussi. Les émissions étant proportionnelles aux surfaces d'après les lois bien connues de la thermodynamique, si l'on veut que les échanges se fassent dans le sens du réchauffement de la source chaude, il faut que la surface d'émission de cette dernière soit dans un rapport avec celle de la source froide qui est le rapport des températures à la puissance 4 des deux sources. Même si un tel rapport de surfaces est techniquement faisable, l'invention va permettre de réduire substantiellement ce dernier.
- le dispositif de récupération de chaleur dissipée comporte un concentrateur réfractif disposé au point focal du panneau radiatif qui renvoie les rayons reçus vers la source chaude.
- la source chaude est disposée derrière le panneau radiatif. Selon l'invention, le dispositif comporte, au droit de ladite zone d'entrée, un concentrateur optique.
- le concentrateur optique présente, face aux rayonnements reçus, une surface convergente, symétrique par rapport à un axe vertical Z.
- la surface convergente est une surface courbe sans angle telle que, en tout point le long de ladite surface convergente, un rayon incident reçu selon la verticale Z, est renvoyé vers le col de la surface convergente.
- dans le cas où le panneau radiatif est de type cylindre parabolique avec une directrice selon un axe longitudinal X, la surface convergente est formée de deux demi-surfaces de type cylindre parabolique.
- la section droite de la surface convergente est formée de segments rectilignes approximant une parabole.
- le concentrateur optique présente, face aux rayonnements reçus, une surface concentratrice qui sert à la fois à concentrer les rayons incidents vers la zone d'entrée, et à rejeter vers ladite zone d'entrée des rayons sortant radialement de la source chaude. De tels concentrateurs réfractifs ont en général des surfaces lisses et réfléchissantes.
- la section droite de la surface concentratrice pour l'invention est formée d'une série de segments en zigzag convergeant vers la zone d'entrée, la forme de cette section étant telle que les rayons infrarouges émis par la source chaude viennent, dans la plus grande partie de l'angle solide d'émission, rencontrer une partie de la surface concentratrice formant localement réflecteur vers la zone d'entrée, et que, par contre, les rayons infrarouges issus du panneau radiatif viennent se réfléchir sur des parois successives dont les angles sont agencés de telle façon que tout rayon incident selon la verticale Z est renvoyé vers le col de la surface concentratrice. Le cas échéant, les segments seront courbes de même courbure locale que celle d'un concentrateur lisse.
- le générateur thermoélectrique est de type thermo-acoustique.

Dans un mode particulier de réalisation, le dispositif combine, au niveau de la source chaude :
- d'une part, une zone d'entrée adaptée à recevoir les rayons infrarouges émis par le ou les panneaux radiatifs, et,
- d'autre part, une seconde zone d'entrée adaptée à recevoir des rayonnements solaires concentrés par le concentrateur principal,

La direction Z à laquelle fait face le panneau radiatif étant sensiblement orientée à 90° de la direction de laquelle proviennent les rayonnements solaires.

L'invention vise en second lieu un satellite, comportant un dispositif tel qu'exposé.

### Présentation des figures

La description qui va suivre, donnée uniquement à titre d'exemple d'un mode de réalisation de l'invention, est faite en se référant aux figures annexées dans lesquelles
- La figure 1 montre sous forme schématique les éléments principaux mis en oeuvre dans l'invention,
- La figure 2 illustre, également de façon schématique, un concentrateur réfractif de rayonnements, utilisé dans un exemple de mise en oeuvre de l'invention,
- La figure 3 illustre, de façon similaire, un second concentrateur de rayonnements, utilisé dans une variante de mise en oeuvre de l'invention,
- La figure 4 illustre en vue de face, de côté et en perspective une des configurations possibles d'un satellite dont la génération électrique se fait par moteur thermoacoustique.

### Description détaillée d'un mode de réalisation de l'invention

L'invention est destinée à être mise en oeuvre dans un environnement de vide poussé, tel que celui qui existe en orbite terrestre ou plus généralement entre les astres. Dans ces conditions de vide, il est connu que le transfert de chaleur entre deux corps distants se fait uniquement par rayonnement.

L'invention trouve par exemple sa place en tant que partie d'un véhicule spatial, tel qu'un satellite en orbite terrestre ou une sonde.

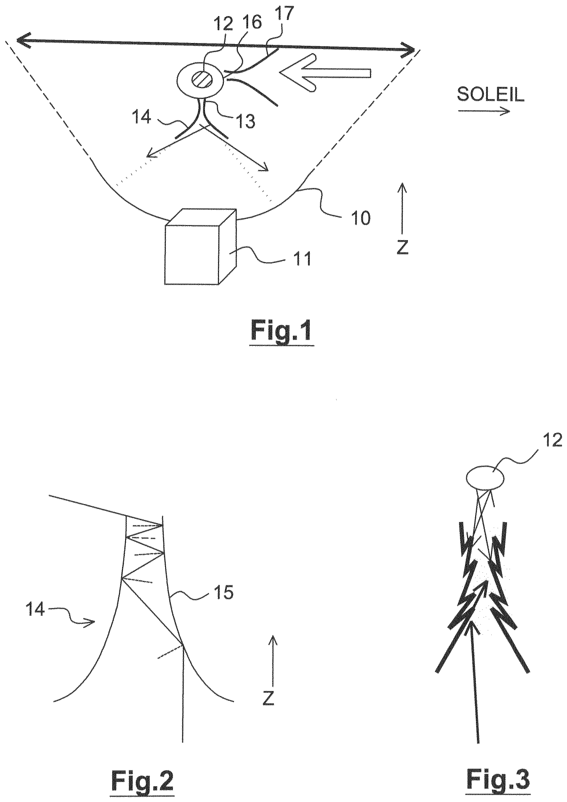

Comme on le voit sur la figure 1, un dispositif de récupération de chaleur dissipée par la charge utile du satellite comporte en premier lieu, dans le présent exemple de réalisation, au moins un panneau radiatif 10 solidarisé au corps 11 du satellite, ici schématisé à titre purement explicatif par un simple cube. Il est clair que le dispositif peut comporter un nombre quelconque de panneaux radiatifs 10, selon les besoins ou contraintes du satellite sur lequel ils sont installés. Ces panneaux radiatifs 10 sont préférentiellement orientés dans une direction ne faisant pas face au soleil, de manière à augmenter leur efficacité de refroidissement. Ils sont ici orientés, par exemple, à 90° de la direction solaire.

Chaque panneau radiatif 10 est supposé relié à la charge utile dissipative du satellite par des moyens connus en soi, par exemple des caloducs, qui sortent en tant que tels du cadre de la présente invention. Il est simplement admis ici que la chaleur dissipée par lesdits équipements dissipatifs est transférée jusqu'au panneau radiatif 10, dont la fonction est de rayonner cette chaleur vers l'espace sous forme de photons infrarouges.

Les matériaux dont est constitué le panneau radiatif 10 sont supposés connus en soi, de même que son architecture interne. Ces matériaux et cette architecture sont adaptés à ce que le panneau radiatif 10 émette dans une direction principale des photons infrarouges. Dans le présent exemple de réalisation, le panneau radiatif se présente sous la forme d'une surface incurvée, dont une face est radiative, alors que l'autre face est isolée, de manière à éviter le rayonnement, notamment vers le corps du satellite qu'on cherche à refroidir.

Dans le présent exemple de réalisation nullement limitatif, le panneau radiatif 10 est incurvé de manière à ce que la plus grande partie possible des photons émis par ledit panneau radiatif 10 convergent vers une zone prédéterminée de l'espace face audit panneau radiatif 10. Dans l'exemple illustré figure 1, le panneau radiatif 10 est configuré sous forme d'une surface sensiblement rectangulaire, incurvée autour d'un axe longitudinal X de manière à présenter une section parabolique perpendiculairement à cet axe longitudinal X. Il s'agit alors d'un cylindre parabolique. De la sorte, les photons émis par le panneau radiatif 10 vont naturellement converger vers la ligne formant, le long de l'axe longitudinal X, le point focal de la parabole.

Dans des variantes non limitatives de réalisation, le panneau radiatif peut être configuré sous forme d'un paraboloïde de révolution autour de l'axe vertical Z, ou alternativement d'un tore de section parabolique. Dans le premier cas, la zone de focalisation est sensiblement ponctuelle. Dans le second cas, la zone de focalisation est un cercle situé face au tore.

Dans une autre variante de réalisation, le panneau radiatif 10 est réalisé sous forme d'un ensemble de surfaces planes connexes articulées disposées, une fois déployées, de façon à approximer un cylindre parabolique. Une telle disposition est avantageuse pour des questions de stockage d'un tel panneau radiatif lors du lancement du satellite, sous forme d'un empilement de surfaces articulées.

Une source chaude 12, disposée en la zone de focalisation des rayons émis par la surface émettrice du panneau radiatif, va naturellement venir s'échauffer sous l'effet des rayonnements infrarouges émis par le panneau radiatif 10 et concentrés en ce point. Cette source chaude 12 est supposée complètement isolée thermiquement, sauf en une zone d'entrée 13 des rayonnements thermique reçus du panneau radiatif, ladite zone d'entrée 13 étant figurée ici face au panneau radiatif 10. De cette manière, la source chaude 12 se comporte comme un corps noir isolé.

Alternativement, le dispositif de récupération de chaleur dissipée comporte d'abord un miroir secondaire disposé au point focal du panneau radiatif (en place de la source chaude 12 illustrée figure 1), et qui renvoie les rayons reçus vers la source chaude 12, celle-ci étant alors, par exemple, disposée derrière le panneau radiatif 10.

De manière à réduire les déperditions de chaleur de la source chaude 12 vers le panneau radiatif 10 au niveau de la zone d'entrée 13, les dimensions de cette zone d'entrée 13 sont réduites, et le dispositif comporte, dans le présent exemple de réalisation, au droit de ladite zone d'entrée 13, un concentrateur optique 14, dont la section est mieux visible figure 2.

Comme on le voit sur cette figure donnée à titre d'exemple non limitatif de réalisation, le concentrateur optique 14 présente, face aux rayonnements reçus, une surface convergente 15, symétrique par rapport à un axe vertical Z. Cette surface convergente 15 est ici une surface courbe sans angle telle que, en tout point le long de ladite surface convergente 15, un rayon incident reçu selon la verticale Z, est réfléchi (ou réfracté) vers le col de la surface convergente 15.

Dans le cas où le panneau radiatif 10 est de type cylindre parabolique avec une directrice selon un axe longitudinal X, la surface convergente sera formée de deux demi-surfaces de type parabolique.

Dans le cas où le panneau radiatif est de type paraboloïde de révolution, la surface convergente présente une symétrie de révolution autour de l'axe vertical Z.

Dans le cas d'un panneau radiatif de type tore à section parabolique, la surface convergente peut avantageusement présenter une surface torique de révolution, à section telle que décrite plus haut.

La figure 2 illustre le trajet d'un rayon lumineux incident selon la verticale Z, qui vient se refléter plusieurs fois sur les deux surfaces symétriques de la surface convergente 15, en avançant vers le col de ladite surface convergente 15.

Dans une variante de réalisation (non illustrée sur les figures), la section droite de la surface convergente 15 est formée de segments rectilignes approximant une hyperbole.

Dans une autre variante de réalisation, la surface convergente 15 est remplacée par une surface concentratrice 15' qui sert à la fois à concentrer les rayons incidents vers la zone d'entrée 13, et à rejeter vers ladite zone d'entrée 13 des rayons sortant radialement de la source chaude 12.

Pour atteindre ce but, la surface concentratrice présente une section illustrée à titre d'exemple non limitatif en figure 3.

Comme on le voit sur cette figure, la section droite de la surface concentratrice 15' est formée d'une série de segments, le cas échéant « de type hyperbolique » en zigzag convergeant vers la zone d'entrée 13. Du fait de la forme de cette section, les rayons infrarouges émis par la source chaude 12 viennent, dans la plus grande partie de l'angle solide d'émission, rencontrer une partie de la surface concentratrice 15' formant localement réflecteur vers la zone d'entrée 13. Par contre, les rayons infrarouges issus du panneau radiatif 10 viennent se réfléchir sur des parois successives dont les angles sont agencés de telle façon que tout rayon incident selon la verticale Z est renvoyé vers le col de la surface concentratrice 15'. Au final, le dispositif favorise une énergie reçue du panneau radiatif, sous forme de photons infrarouges, plus importante que celle émise par la source chaude, ce en permettant un rapport de surface plus facilement réalisable que dans une application triviale des principes de la thermodynamique.

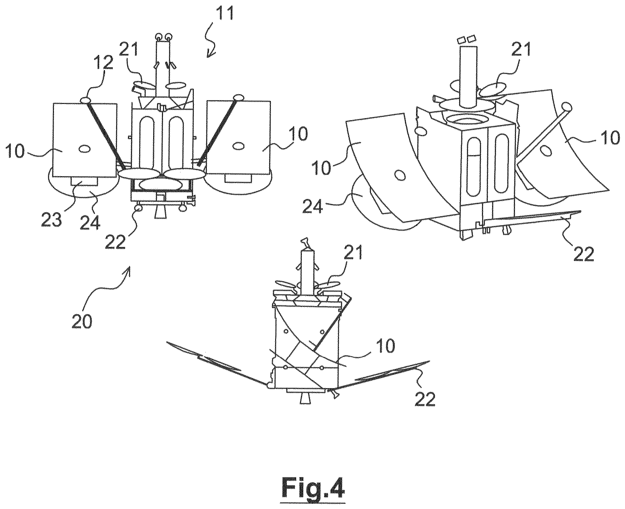

Sur la figure 4, la surface concentratrice 15' comporte de chaque côté une dizaine de segments. Il est clair qu'il est possible, en variante, d'utiliser un nombre plus ou moins grand de segments. De même, ces segments rectilignes peuvent être remplacés par des lignes courbes telles que des segments de parabole et/ou hyperbole.

Le dispositif de récupération de chaleur est complété par un générateur électrique (non illustré sur les figures), adapté à transformer l'énergie thermique en énergie électrique, par exemple un générateur de type thermo-acoustique, connu en soi.

Dans le cas particulier où le satellite est alimenté en énergie électrique par un générateur thermo-acoustique, la source chaude 12 du dispositif de récupération de chaleur dissipée par le panneau radiatif 10 peut être confondue avec la source chaude du générateur thermo-acoustique principal.

De même, et ainsi qu'illustré par la figure 1, déjà citée, il est possible dans une variante de réalisation, de combiner, au niveau de la source chaude 12 :
- d'une part, une zone d'entrée 13 adaptée à recevoir les rayons infrarouges émis par le ou les panneaux radiatifs 10, et,
- d'autre part, une seconde zone d'entrée 16 adaptée à recevoir des rayonnements solaires concentrés par un second concentrateur 17.

Comme on le voit alors sur cette figure 1, la direction Z à laquelle fait face le panneau radiatif 10 est sensiblement orientée à 90° de la direction de laquelle proviennent les rayonnements solaires issus du dispositif de concentration constituant la source d'énergie primaire.

La figure 4 illustre de façon simplifiée une configuration possible d'un satellite équipé d'un dispositif de génération électrique par concentration solaire.

Sur cette figure, on reconnaît un satellite 20 dont le corps 11 supporte ici un ensemble d'équipements 21, 22. Le corps 11 est solidarisé à deux panneaux réfléchissants situés de part et d'autre dudit corps 11. Ces panneaux réfléchissants sont ici configurés en cylindre parabolique. Ils font ici face au Soleil.

Chaque panneau réfléchissant est ici représenté attaché à un bloc moteur 23, lui-même attaché à un radiateur froid du moteur 24.

Les panneaux réfléchissants font ici face à des miroirs secondaires 24, représentés ici sous forme de deux zones ponctuelles. Ces miroirs secondaires 24 renvoient les rayonnements reçus vers des sources chaudes, disposées derrière les panneaux réfléchissants, ceux-ci comportant un évidemment central pour le passage de ces rayonnements concentrés.

### Mode de fonctionnement

Pour que le dispositif de récupération de chaleur dissipée fonctionne, il est nécessaire que le rayonnement émis par la source chaude 12 à travers la zone d'entrée 13, reste inférieur au rayonnement reçu des panneaux radiatifs 10 par cette même zone d'entrée 13. Cette condition est respectée, dans le cas donné ici à titre d'exemple purement illustratif d'une température de source chaude 12 de 1000°C et d'un panneau radiatif 10 à 100°C, si le rapport de surface entre le panneau radiatif 10 et la zone d'entrée 13 de la source chaude 12 est supérieur à environ 135. Dans le cas où le dispositif comporte une surface concentrique 15' susceptible de renvoyer une large partie des rayons émis par la source chaude 12 vers celle-ci du fait d'une émission nécessairement isotrope, ce rapport de surface se trouve sensiblement diminué.

A titre d'exemple d'utilisation, en supposant le cas d'un satellite consommant 5 kW d'énergie électrique, et utilisant pour la génération d'électricité, la surface de des panneaux peut être grossièrement estimée à 12 m2 si ces panneaux ont un rendement de 30% et si le rayonnement solaire est estimée à 1,3 kW/m2.

En supposant alors que le satellite crée 4 kW sous forme de chaleur due à l'effet Joule, qu'il soit capable d'une émission de 2kW par l'intermédiaire de ses panneaux radiatifs 10, avec l'installation d'un dispositif de récupération de chaleur dissipée, tel que décrit plus haut, la surface de panneaux nécessaire à l'alimentation du satellite est réduite à 10 m2. L'économie générée sur la surface est donc de l'ordre de 20%. Pour des applications à forte puissance, les économies de surface et surtout de masse seront donc substantielles.

## Revendications

1. Dispositif de récupération d'une partie de l'énergie dissipée par effet Joule par les équipements d'un satellite prédéterminé placé en ambiance de vide, comprenant au moins un panneau radiatif (10) dimensionné pour permettre le refroidissement de la charge utile du satellite (20) et un générateur thermoélectrique dont la source chaude (12) est alimentée en photons infrarouges par les panneaux radiatifs (10), ceux-ci étant configurés pour concentrer lesdits photos infrarouges vers ladite source chaude (12), **caractérisé en ce qu'**au moins un panneau radiatif (10) se présente sous la forme d'une surface, dont une face est radiative, alors que l'autre face est isolée, de manière à éviter le rayonnement, notamment vers le corps du satellite, le panneau radiatif (10) étant incurvé de manière à ce que la plus grande partie possible des photons émis par ledit panneau radiatif (10) convergent vers une zone prédéterminée de l'espace face audit panneau radiatif (10), **en ce que** la source chaude (12) est disposée en la zone de focalisation des rayons émis par la surface émettrice du panneau radiatif, ladite source chaude étant isolée thermiquement, sauf en au moins une zone d'entrée (13) des rayonnements thermique reçus du panneau radiatif (10), et **en ce que** le dispositif de récupération d'énergie thermique comporte, au droit de ladite zone d'entrée (13), un concentrateur optique (14).

2. Dispositif de récupération d'énergie thermique selon la revendication 1, **caractérisé en ce que** le panneau radiatif (10) est configuré sous forme d'une surface sensiblement rectangulaire, incurvée autour d'un axe longitudinal X de manière à présenter une section parabolique perpendiculairement à cet axe longitudinal X.

3. Dispositif de récupération d'énergie thermique selon la revendication 1, **caractérisé en ce que** le panneau radiatif (10) est réalisé sous forme d'un ensemble de surfaces planes connexes articulées empilables, disposées lorsqu'elles sont déployées, de façon à approximer un cylindre parabolique.

4. Dispositif de récupération d'énergie thermique selon l'une quelconque des revendications 1 à 3, **caractérisé en ce que** le dispositif de récupération de chaleur dissipée comporte un miroir secondaire disposé au point focal du panneau radiatif qui renvoie les rayons reçus vers la source chaude (12).

5. Dispositif de récupération d'énergie thermique selon la revendication 4, **caractérisé en ce que** la source chaude est disposée derrière le panneau radiatif (10).

6. Dispositif de récupération d'énergie thermique selon la revendication 1, **caractérisé en ce que** le concentrateur optique (14) présente, face aux rayonnements reçus, une surface convergente (15), symétrique par rapport à un axe vertical Z.

7. Dispositif de récupération d'énergie thermique selon la revendication 6, **caractérisé en ce que** la surface convergente (15) est une surface courbe sans angle telle que, en tout point le long de ladite surface convergente (15), un rayon incident reçu selon la verticale Z, est renvoyé vers le col de la surface convergente (15).

8. Dispositif de récupération d'énergie thermique selon la revendication 7, adaptée au cas où le panneau radiatif (10) est de type cylindre parabolique avec une directrice selon un axe longitudinal X, **caractérisé en ce que** la surface convergente est formée de deux demi-surfaces de type cylindre parabolique.

9. Dispositif de récupération d'énergie thermique selon la revendication 6, **caractérisé en ce que** la section droite de la surface convergente (15) est formée de segments rectilignes et/ ou courbes approximant une parabole.

10. Dispositif de récupération d'énergie thermique selon la revendication 1, **caractérisé en ce que** le concentrateur optique présente, face aux rayonnements reçus, une surface concentratrice (15') qui sert à la fois à concentrer les rayons incidents vers la zone d'entrée (13), et à rejeter vers ladite zone d'entrée (13) des rayons sortant radialement de la source chaude (12).

11. Dispositif de récupération d'énergie thermique selon la revendication 10, **caractérisé en ce que** la section droite de la surface concentratrice (15') est formée d'une série de segments en zigzag convergent vers la zone d'entrée (13), la forme de cette section étant telle que les rayons infrarouges émis par la source chaude (12) viennent, dans la plus grande partie de l'angle solide d'émission, rencontrer une partie de la surface concentratrice (15') formant localement réflecteur vers la zone d'entrée (13), et que, par contre, les rayons infrarouges issus du panneau radiatif (10) viennent se réfléchir sur des parois successives dont les angles sont agencés de telle façon que tout rayon incident selon la verticale Z est renvoyé vers le col de la surface concentratrice (15').

12. Dispositif de récupération d'énergie thermique selon l'une quelconque des revendications 1 à 11, **caractérisé en ce que** le générateur thermoélectrique est de type thermo-acoustique.

13. Dispositif de récupération d'énergie thermique selon la revendication 12, **caractérisé en ce qu'**il combine, au niveau de la source chaude (12) :
- d'une part, une zone d'entrée (13) adaptée à recevoir les rayons infrarouges émis par le ou les panneaux radiatifs (10), et,
- d'autre part, une seconde zone d'entrée (16) adaptée à recevoir des rayonnements solaires concentrés par un second concentrateur (17),
la direction Z à laquelle fait face le panneau radiatif (10) étant sensiblement orientée à 90° de la direction de laquelle proviennent les rayonnements solaires.

14. Véhicule spatial, **caractérisé en ce qu'**il comporte un dispositif de récupération d'énergie thermique selon l'une quelconque des revendications 1 à 13.

## Patentansprüche

1. Vorrichtung zur Rückgewinnung eines Teils der Energie, die durch Joule-Effekt von den Ausrüstungen eines bestimmten im Vakuum befindlichen Satelliten abgegeben wird, umfassend mindestens ein Strahlungspaneel (10), das so dimensioniert ist, dass es die Kühlung der Nutzlast des Satelliten (20) ermöglicht, und einen thermoelektrischen Generator, dessen Wärmequelle (12) mit Infrarot-Photonen von den Strahlungspaneelen (10) versorgt wird, die so gestaltet sind, dass sie die Infrarot-Photonen zu der Wärmequelle (12) hin konzentrieren,
**dadurch gekennzeichnet, dass** mindestens ein Strahlungspaneel (10) in Form einer Fläche vorliegt, deren eine Seite strahlend ist, während die andere Seite isoliert ist, so dass die Strahlung, insbesondere zum Körper des Satelliten hin, verhindert wird, wobei das Strahlungspaneel (10) einwärts gekrümmt ist, so dass der größtmögliche Teil der von dem Strahlungspaneel (10) ausgesendeten Photonen zu einem vorgegebenen Bereich des Raums gegenüber dem Strahlungspaneel (10) konvergiert, dass die Wärmequelle (12) im Fokussierungsbereich der von der aussendenden Fläche des Strahlungspaneels ausgesendeten Strahlen angeordnet ist, wobei die Wärmequelle außer an mindestens einem Eintrittsbereich (13) der vom Strahlungspaneel (10) empfangenen Wärmestrahlung thermisch isoliert ist, und dass die Vorrichtung zur Rückgewinnung von Wärmeenergie an dem Eintrittsbereich (13) einen optischen Konzentrator (14) aufweist.

2. Vorrichtung zur Rückgewinnung von Wärmeenergie nach Anspruch 1, **dadurch gekennzeichnet, dass** das Strahlungspaneel (10) in Form einer im Wesentlichen rechteckigen Fläche gestaltet ist, die um eine Längsachse X so einwärts gekrümmt ist, dass sie senkrecht zu dieser Längsachse X einen parabolischen Querschnitt aufweist.

3. Vorrichtung zur Rückgewinnung von Wärmeenergie nach Anspruch 1, **dadurch gekennzeichnet, dass** das Strahlungspaneel (10) in Form einer Anordnung von stapelbaren angelenkten verbundenen ebenen Flächen ausgeführt ist, die, wenn sie ausgebreitet sind, so angeordnet sind, dass sie sich einem parabolischen Zylinder annähern.

4. Vorrichtung zur Rückgewinnung von Wärmeenergie nach einem der Ansprüche 1 bis 3, **dadurch gekennzeichnet, dass** die Vorrichtung zur Rückgewinnung abgegebener Wärme einen im Brennpunkt des Strahlungspaneels angeordneten zweiten Spiegel umfasst, der die empfangenen Strahlen zur Wärmequelle (12) umlenkt.

5. Vorrichtung zur Rückgewinnung von Wärmeenergie nach Anspruch 4, **dadurch gekennzeichnet, dass** die Wärmequelle hinter dem Strahlungspaneel (10) angeordnet ist.

6. Vorrichtung zur Rückgewinnung von Wärmeenergie nach Anspruch 1, **dadurch gekennzeichnet, dass** der optische Konzentrator (14) gegenüber den empfangenen Strahlungen eine konvergente Fläche (15) aufweist, die in Bezug auf eine vertikale Achse Z symmetrisch ist.

7. Vorrichtung zur Rückgewinnung von Wärmeenergie nach Anspruch 6, **dadurch gekennzeichnet, dass** die konvergente Fläche (15) eine gewölbte Fläche ohne Ecken ist, so dass ein einfallender Strahl, der entlang der Vertikalen Z empfangen wird, an jedem Punkt entlang der konvergenten Fläche (15) zum Hals der konvergenten Fläche (15) umgelenkt wird.

8. Vorrichtung zur Rückgewinnung von Wärmeenergie nach Anspruch 7, die für den Fall geeignet ist, in dem das Strahlungspaneel (10) vom Typ eines parabolischen Zylinders mit einer Leitkurve entlang einer Längsachse X ist, **dadurch gekennzeichnet, dass** die konvergente Fläche aus zwei Halbflächen vom Typ eines parabolischen Zylinders gebildet ist.

9. Vorrichtung zur Rückgewinnung von Wärmeenergie nach Anspruch 6, **dadurch gekennzeichnet, dass** der Querschnitt der konvergenten Fläche (15) aus geradlinigen und/oder gekrümmten Segmenten gebildet wird, die sich einer Parabel annähern.

10. Vorrichtung zur Rückgewinnung von Wärmeenergie nach Anspruch 1, **dadurch gekennzeichnet, dass** der optische Konzentrator gegenüber den empfangenen Strahlungen eine konzentrierende Fläche (15') aufweist, die sowohl dazu dient, die einfallenden Strahlen zum Eintrittsbereich (13) hin zu konzentrieren, als auch dazu, radial aus der Wärmequelle (12) austretende Strahlen zu dem Eintrittsbereich (13) zurückzuweisen.

11. Vorrichtung zur Rückgewinnung von Wärmeenergie nach Anspruch 10, **dadurch gekennzeichnet, dass** der Querschnitt der konzentrierenden Fläche (15') aus einer Reihe von zickzackförmigen, zum Eintrittsbereich (13) hin konvergierenden Segmenten gebildet wird, wobei die Form dieses Querschnitts dergestalt ist, dass die von der Wärmequelle (12) ausgesendeten Infrarotstrahlen im größten Teil des räumlichen Aussendewinkels auf einen Teil der konzentrierenden Fläche (15') treffen, die lokal einen Reflektor zum Eintrittsbereich (13) hin bildet, und dass dagegen die Infrarotstrahlen aus dem Strahlungspaneel (10) an aufeinander folgenden Wänden reflektiert werden, deren Winkel so angeordnet sind, dass jeder entlang der Vertikalen Z einfallende Strahl zum Hals der konzentrierenden Fläche (15') umgelenkt wird.

12. Vorrichtung zur Rückgewinnung von Wärmeenergie nach einem der Ansprüche 1 bis 11, **dadurch gekennzeichnet, dass** der thermoelektrische Generator vom thermoakustischen Typ ist.

13. Vorrichtung zur Rückgewinnung von Wärmeenergie nach Anspruch 12, **dadurch gekennzeichnet, dass** sie auf Ebene der Wärmequelle (12) kombiniert:
- einerseits einen Eintrittsbereich (13), der geeignet ist, die von dem oder den Strahlungspaneelen (10) ausgesendeten Infrarotstrahlen zu empfangen, und
- andererseits einen zweiten Eintrittsbereich (16), der geeignet ist, die von einem zweiten Konzentrator (17) konzentrierte Sonnenstrahlung zu empfangen,
wobei die Richtung Z, der das Strahlungspaneel (10) gegenüber liegt, im Wesentlichen in einem Winkel von 90° zu der Richtung ausgerichtet ist, aus der die Sonnenstrahlung kommt.

14. Raumfahrzeug, **dadurch gekennzeichnet, dass** es mindestens eine Vorrichtung zur Rückgewinnung von Wärmeenergie nach einem der Ansprüche 1 bis 13 umfasst.

## Claims

1. Device for the recovery of a proportion of the energy which is dissipated, by the Joule effect, by the equipment of a predetermined satellite in a vacuum atmosphere, comprising at least one radiative panel (10), which is designed to permit the cooling of the satellite (20) payload, and a thermoelectric generator, the heat source (12) of which is supplied with infrared photons by the radiative panels (10), whereby the latter are configured to concentrate said infrared photons towards said heat source (12), **characterized in that** at least one radiative panel (10) is configured in the form of a surface, one side of which is radiative, whereas the other side is insulated, specifically for the prevention of radiation towards the body of the satellite, whereby the radiative panel (10) is curved such that the highest possible proportion of the photons emitted by said radiative panel (10) converge towards a predetermined zone of space opposite said radiative panel (10), **in that** the heat source (12) is arranged in the focal zone of the rays emitted by the emitter surface of the radiative panel, said heat source being thermally insulated, except at at least one input zone (13) of the thermal radiation received from the radiative panel (10), and **in that** the device for the recovery of thermal energy comprises an optical concentrator (14) which is perpendicular to said input zone (13).

2. Device for the recovery of thermal energy according to Claim 1, **characterized in that** the radiative panel (10) is configured in the form of a substantially rectangular surface, curved around a longitudinal axis X such that it shows a parabolic cross section perpendicularly to this longitudinal axis X.

3. Device for the recovery of thermal energy according to Claim 1, **characterized in that** the radiative panel (10) is configured in the form of a series of stackable and articulated connected plane surfaces which are arranged, when deployed, in approximation to a parabolic cylinder.

4. Device for the recovery of thermal energy according to any one of Claims 1 to 3, **characterized in that** the device for the recovery of dissipated heat comprises a secondary reflector, arranged at the focal point of the radiative panel, which directs the rays received towards the heat source (12).

5. Device for the recovery of thermal energy according to Claim 4, **characterized in that** the heat source is arranged behind the radiative panel (10).

6. Device for the recovery of thermal energy according to Claim 1, **characterized in that** the optical concentrator (14), facing the radiation received, is configured with a convergent surface (15) which is symmetrical in relation to a vertical axis Z.

7. Device for the recovery of thermal energy according to Claim 6, **characterized in that** the convergent surface (15) is a curved surface free of angles such that, at any point along said convergent surface (15), an incident ray received in the vertical axis Z is directed towards the throat of the convergent surface (15).

8. Device for the recovery of thermal energy according to Claim 7, designed for the case where the radiative panel (10) is of the parabolic cylinder type, with a directrix arranged in a longitudinal axis X, **characterized in that** the convergent surface is formed of two half-surfaces of the parabolic cylinder type.

9. Device for the recovery of thermal energy according to Claim 6, **characterized in that** the perpendicular cross section of the convergent surface (15) is formed of rectilinear and/or curved segments, approximating to a parabola.

10. Device for the recovery of thermal energy according to Claim 1, **characterized in that** the optical concentrator, facing the radiation received, is configured with a concentrating surface (15') which simultaneously serves to concentrate the incident rays towards the input zone (13), and to reject towards said input zone (13) rays emitted radially by the heat source (12).

11. Device for the recovery of thermal energy according to Claim 10, **characterized in that** the perpendicular cross section of the concentrating surface (15') is formed of a series of segments, in a zig-zag arrangement, converging towards the input zone (13), whereby the profile of this cross section is such that the infrared rays emitted by the heat source (12), in the greatest proportion of the solid angle of emission, strike a part of the concentrating surface (15') which forms a localized reflector towards the input zone (13) and, conversely, the infrared rays originating from the radiative panel (10) are reflected on successive walls, the angles of which are configured such that any incident ray in the vertical axis Z is directed towards the throat of the concentrating surface (15').

12. Device for the recovery of thermal energy according to any one of Claims 1 to 11, **characterized in that** the thermoelectric generator is of the thermoacoustic type.

13. Device for the recovery of thermal energy according to Claim 12, **characterized in that** it comprises, at the heat source (12), a combination of the following:
∘ firstly, an input zone (13) which is designed for the reception of the infrared rays emitted by the radiative panel(s) (10), and
∘ secondly, a second input zone (16) which is designed for the reception of solar radiation which has been concentrated by a second concentrator (17), whereby the direction Z, opposite which the radiative panel (10) is arranged, is substantially oriented at 90° to the direction of origin of the solar radiation.

14. Space vehicle, **characterized in that** it comprises a device for the recovery of thermal energy according to any one of Claims 1 to 13.
